# EUROPEAN PATENT APPLICATION

(11) **EP 4 632 403 A1**
(43) Date of publication of application: **15.10.2025**
(21) Application number: 23924883.4
(22) Date of filing: 24.08.2023
(51) Int. Cl.: G01R 31/3835, G01R 31/396, G01R 31/385

(54) **FAULT RECOGNITION METHOD FOR BATTERY CELLS OF ENERGY STORAGE SYSTEM, AND ENERGY STORAGE SYSTEM**

(30) Priority: 02.03.2023 CN 202310215724
(71) Applicant: Hefei Gotion High-Tech Power Energy Co., Ltd., Hefei, Anhui 230012 (CN)
(72) Inventor: LU, Kai, Hefei, Anhui 230012 (CN); CHEN, Xiaohu, Hefei, Anhui 230012 (CN); CHENG, Qianqian, Hefei, Anhui 230012 (CN)
(74) Representative: Studio Torta S.p.A.
(86) International application number: PCT/CN2023/114789
(87) International publication number: WO 2024/178926

(57) **Abstract**

A battery cell fault identification method for an energy storage system and an energy storage system are provided. The battery cell fault identification method for the energy storage system includes: setting an upper threshold for a cell voltage deviation; acquiring a cell voltage V_n_i of each battery cell, wherein n denotes a number of battery modules, and i denotes an index of the battery cells within a battery module; performing a horizontal comparison on the battery cells to acquire a deviation ΔV_n_i of the cell voltage of each of battery cells relative to an average cell voltage within a same battery module; and performing a vertical comparison on the battery cells, calculating a difference between the deviations of battery cells with a same index within each battery module and a median value of the deviations of the battery cells with the same index, and if the difference exceeds the upper threshold for the cell voltage deviation, determining that the battery cell corresponding to the difference is faulty. The battery cell fault identification method for the energy storage system accurately identifies voltage deviations of battery cells, promptly detects faults in the battery cells within the energy storage system, and enhances system safety.

## Description

The present application claims priority to Chinese Patent Application No. 202310215724.7, filed on March 2, 2023, titled "Battery Cell Fault Identification Method for Energy Storage System and Energy Storage System".

### Technical Field

The present invention relates to the technical field of batteries, and in particular to a battery cell fault identification method for an energy storage system and an energy storage system.

### Background

An energy storage system comprises at least a plurality of battery modules. Each battery module is formed by connecting a plurality of battery cells in series or in parallel. Each battery module is configured with a battery management system for collecting information such as voltage, current, and temperature of the battery module, estimating the state of charge (SOC) and state of health (SOH) of batteries, and identifying and diagnosing faults in battery cells.

In the related art, a power battery consistency safety status evaluation method has been disclosed, including: acquiring a large amount of historical operating data of a vehicle to be evaluated; calculating standard deviation features and variance entropy consistency features of a cell voltage in each charging data segment to obtain feature values; acquiring the number of charge/discharge cycles; using the feature values to construct a feature matrix, and performing unsupervised training on the feature matrix using a preset algorithm to obtain a confusion matrix; and constructing a power battery consistency safety status quantitative calculation model based on the confusion matrix. By performing a quantitative evaluation of the consistency safety status of the power battery, potential risk factors can be more intuitively identified and analyzed from a large amount of historical operating data. This method requires dynamically identifying the evaluation of the internal consistency of the vehicle after a period of operation, and a large amount of historical data is needed to optimize the model. Moreover, conventional battery cell fault diagnosis methods for a battery management system (BMS) in the current industry typically determine faults by setting an upper threshold between the cell voltage and the average voltage. When the cell voltage significantly exceeds the average voltage, the cell is determined to be faulty. Although this method is simple, it is prone to both false positives and false negatives. The main reason is that, after battery cells are assembled into modules, inconsistencies arise due to differences in the external circuitry of the battery cells (including electric connector circuits and sampling line circuits). Even if all battery cells have identical factory conditions, inconsistencies may still exist among the battery cells as detected by the BMS after the battery cells are assembled into the battery modules. As a result, if a battery cell with an initially high or low voltage experiences a fault that causes the voltage to drop or rise, the cell voltage may still fall within the upper threshold range based on the average voltage, and the BMS may fail to identify the fault promptly, thereby posing significant safety risks.

### Summary

The main objective of the present invention is to provide a battery cell fault identification method for an energy storage system and an energy storage system, which is capable of accurately identifying voltage deviations of battery cells, promptly detecting faults in battery cells within the energy storage system, and improving system safety.

To achieve the above objective, according to one aspect of the present invention, a battery cell fault identification method for an energy storage system is provided, including:
setting an upper threshold for a cell voltage deviation;
acquiring a cell voltage V_n_i of each battery cell, where n denotes a number of battery modules, and i denotes an index of the battery cells within each of the battery modules;
performing a horizontal comparison on the battery cells to acquire a deviation ΔV_n_i of the cell voltage of each of battery cells within a same battery module relative to an average cell voltage of the battery cells within the same battery module; and
performing a vertical comparison on the battery cells, calculating a difference between the deviations of the battery cells with a same index within each of the battery modules and a median value of the deviations of the battery cells with a same index within the each of the battery modules, and if the difference exceeds the upper threshold for the cell voltage deviation, determining that a battery cell corresponding to the difference is faulty.

In one embodiment, a step of performing a horizontal comparison on the battery cells to acquire a deviation ΔV_n_i of the cell voltage of each of the battery cells within a same battery module relative to an average cell voltage of the battery cells within the same battery module includes:
acquiring an average cell voltage within an nth battery module: ave_v_n=(v_1+v_2+...v_i)/i; and
calculating the deviation of the cell voltage V_n_i within the same battery module relative to the average cell voltage, wherein ΔV_n_i=V_n_i-ave_v_n.

In one embodiment, a step of performing a vertical comparison on the battery cells, calculating a difference between the deviations of the battery cells with the same index within each of the battery modules and a median value of the deviations of the battery cells with the same index within each of the battery modules, and if the difference exceeds the upper threshold for the cell voltage deviation, determining that the battery cell corresponding to the difference is faulty, includes:
sorting the deviations ΔV_n_i of cell voltages of the battery cells with the same index within all the battery modules in ascending order, and acquiring the median value H_n_imid, a maximum value H_n_imax and a minimum value H_n_imin of the deviations ΔV_n_i of the cell voltages of the battery cells with the same index; and
calculating a maximum voltage deviation value of the battery cells with the same index relative to the median value, expressed as: MAX = max[(H_n_imax-H_n_imid), (H_n_imid-H_n_imin)].

In one embodiment, the step of performing a vertical comparison on the battery cells, calculating a difference between the deviations of the battery cells with the same index within each of the battery modules and a median value of the deviations of the battery cells with the same index within each of the battery modules, and if the difference exceeds the upper threshold for the cell voltage deviation, determining that the battery cell corresponding to the difference is faulty, further includes:
determining an index of battery cells for which the difference exceeds the upper threshold for the cell voltage deviation;
determining, based on the index of the battery cells, a BMS that uploads data; and
determining a corresponding battery module based on the BMS that uploads the data.

In one embodiment, each of the battery modules includes a BMS, and the battery cells in the each of the battery modules upload data to a microgrid controller via the BMS.

In one embodiment, the battery cell fault identification method for the energy storage system further includes:
when a fault is detected in a battery cell of the battery cells, stopping charging and discharging of the battery module in which the faulty battery cell is located.

In one embodiment, the upper threshold for the cell voltage deviation is obtained through experiments or empirical formulas.

According to another aspect of the present invention, an energy storage system is provided, applying the battery cell fault identification method for the energy storage system described above. The energy storage system includes:
n battery modules, the battery modules being arranged in parallel, wherein each of the battery modules includes a BMS and a plurality of battery cells, and the plurality of battery cells are connected in series and/or in parallel; and
a microgrid controller, communicatively connected with the BMS of the each of the battery modules to acquire battery module parameters collected by the BMS and process the battery module parameters.

In one embodiment, the energy storage system further includes an energy storage converter, which is connected with all the battery modules and controls charging and discharging of the battery modules.

In one embodiment, the energy storage converter is electrically connected with the microgrid controller, and when detecting a fault in at least one battery cell of the plurality of battery cells, the microgrid controller issues a shutdown instruction to the energy storage converter to stop charging and discharging the battery modules.

By applying the technical solution of the present invention, the battery cell fault identification method for the energy storage system includes: setting an upper threshold for a cell voltage deviation; acquiring a cell voltage V_n_i of each battery cell, where n denotes a number of battery modules, and i denotes an index of the battery cells within each of the battery modules; performing a horizontal comparison on the battery cells to acquire a deviation ΔV_n_i of the cell voltage of each of battery cells within a same battery module relative to an average cell voltage of the battery cells within the same battery module; and performing a vertical comparison on the battery cells, calculating a difference between the deviations of the battery cells with a same index within each of the battery modules and a median value of the deviations of the battery cells with a same index within the each of the battery modules, and if the difference exceeds the upper threshold for the cell voltage deviation, determining that a battery cell corresponding to the difference is faulty. The battery cell fault identification method for the energy storage system collects cell voltage datas of a plurality of battery modules, and sets an average voltage of each of the plurality of battery modules as a reference, so that the voltages of the battery cells with the same index or position within each of the plurality of battery modules are comparable; and then finds out a normal voltage of the battery cells with the same index or position by calculating the median value, and sets the normal voltage as the reference to determine an actual voltage deviation of all the battery cells with this index. In this way, the influence of an initial consistency of the battery modules on the identification results is eliminated, thereby avoiding false positives and false negatives in fault detection.

### Brief Description of the Drawings

The accompanying drawings, which constitute a part of the present invention, are used for providing a further understanding of the present invention; and illustrative embodiments of the present invention and descriptions thereof are intended to explain the present invention and are not construed to unduly limit the present invention. In the drawings:
FIG. 1 is a flow diagram of a battery cell fault identification method for an energy storage system according to an embodiment of the present invention; and
FIG. 2 is a structural diagram of an energy storage system according to an embodiment of the present invention.

### Detailed Description of the Embodiments

It should be noted that, without conflict, the embodiments of the present invention and the features in the embodiments can be combined with each other. The present invention will be described in detail below with reference to the accompanying drawings and in conjunction with the embodiments.

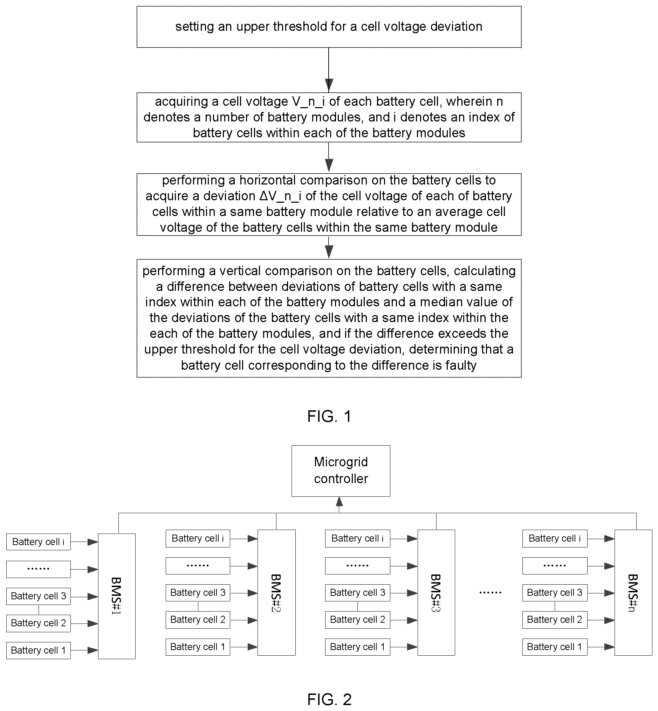

Referring to FIG. 1, the present invention provides a battery cell fault identification method for an energy storage system, including: setting an upper threshold for a cell voltage deviation; acquiring a cell voltage V_n_i of each battery cell, where n denotes a number of battery modules, and i denotes an index of battery cells within each of the battery modules; performing a horizontal comparison on the battery cells to acquire a deviation ΔV_n_i of the cell voltage of each of battery cells within a same battery module relative to an average cell voltage of the battery cells within the same battery module; and performing a vertical comparison on the battery cells, calculating a difference between the deviations of the battery cells with a same index within each of the battery modules and a median value of the deviations of the battery cells with a same index within the each of the battery modules, and if the difference exceeds the upper threshold for the cell voltage deviation, determining that a battery cell corresponding to the difference is faulty.

The battery cell fault identification method for the energy storage system includes: collecting cell voltage datas of a plurality of battery modules, and setting an average voltage of each of the plurality of battery modules as a reference, so that the voltages of the battery cells with the same index or position within each of the plurality of battery modules are comparable; and then finding out a normal voltage of the battery cells with the same index or position by calculating the median value, and setting the normal voltage as the reference to determine an actual voltage deviation of all the battery cells with this index. In this way, the influence of an initial consistency of the battery modules on the identification results is eliminated, thereby avoiding false positives and false negatives in fault detection.

In one embodiment, a step of performing a horizontal comparison on the battery cells to acquire a deviation ΔV_n_i of the cell voltage of each of the battery cells within a same battery module relative to an average cell voltage of the battery cells within the same battery module includes:
acquiring an average cell voltage within an nth battery module: ave_v_n=(v_1+v_2+...v_i)/i; and
calculating the deviation of the cell voltage V_n_i within the same battery module relative to the average cell voltage, wherein ΔV_n_i=V_n_i-ave_v_n.

In this embodiment, the energy storage system includes n battery modules, each of which includes i battery cells connected in series. Accordingly, a cell voltage of an ith battery cell in an nth battery module is denoted as V_n_i. By indexing each battery cell according to a corresponding battery module and the corresponding serial position, the faulty battery cell is able to be quickly identified, and the battery module in which the faulty battery cell is located and the position of the faulty battery cell in the battery module are able to be determined, thereby improving the efficiency and accuracy of battery cell fault diagnosis.

In this embodiment, each battery module includes a battery management system (BMS), and all the battery cells in the battery module are connected with the BMS of the battery module. Thus, the BMS is able to collect a voltage information of all battery cells in the corresponding battery module and upload the voltage information to a microgrid controller, thereby accurately determining the cell voltage of each battery cell.

After each BMS collects the voltage information of all the battery cells in the corresponding battery module and uploads the voltage information to the microgrid controller, an average voltage ave_v_n of all the battery cells in the battery module corresponding to an nth BMS is able to be obtained.

After determining the cell voltage of each battery cell, the average cell voltage of the battery cells within each battery module is able to be determined. Since the battery modules are disposed in parallel and the battery cells within each battery module carry a same current, the battery cells within the same battery module are grouped to calculate the average cell voltage. Then, the deviation of each battery cell within the same battery module relative to the average cell voltage is calculated as ΔV_n_i=V_n_i-ave_v_n.

By performing a horizontal comparison between the cell voltage of the battery cells within the same battery module and the average cell voltage, the deviation ΔV_n_i of the cell voltages of all the battery cells in the battery module corresponding to the BMS relative to the average voltage is able to be obtained. That is, by taking the average value of all cell voltages within the same BMS as a reference, the cell voltages collected by the same BMS are uniformly shifted downward. In this way, the cell voltage data collected by all BMSs are referenced to their respective average voltages, so that the cell voltages of battery cells at the same position but collected by different BMSs become comparable. Since the SOCs of different battery modules vary, the cell voltages across different battery modules also differ. By setting the average voltage as a unified reference, an influence of SOC differences between different battery modules on the cell voltages is able to be eliminated.

In one embodiment, a step of performing a vertical comparison on the battery cells, calculating a difference between the deviations of the battery cells with the same index within each of the battery modules and a median value of the deviations of the battery cells with the same index within each of the battery modules, and if the difference exceeds the upper threshold for the cell voltage deviation, determining that the battery cell corresponding to the difference is faulty, includes:
sorting the deviations ΔV_n_i of cell voltages of the battery cells with the same index within all the battery modules in ascending order, and acquiring the median value H_n_imid, a maximum value H_n_imax and a minimum value H_n_imin of the deviations ΔV_n_i of the cell voltages of the battery cells with the same index; and
calculating a maximum voltage deviation value of the battery cells with the same index relative to the median value, expressed as: MAX = max[(H_n_imax-H_n_imid), (H_n_imid-H_n_imin)].

Due to a positional influence on different battery cells, which may result in significant differences, vertical comparison of the battery cells is necessary to mitigate such differences, i.e., deviation values obtained from the horizontal comparison of each battery cell are compared, thereby eliminating an impact of positional differences of the battery cells at different positions.

In this way, after performing a horizontal comparison on the battery cells to obtain the deviation of the cell voltage of each battery cell relative to the average voltage of the battery cells within the corresponding battery modules, a subsequent vertical comparison is performed on the deviation values of the cell voltages of the battery cells with the same position or index across different battery modules. This effectively eliminates the influences of external circuits and internal environments of the battery cells, thereby significantly enhancing the accuracy and reliability of battery fault diagnosis.

If the MAX value corresponding to the battery cell i exceeds the upper threshold for the cell voltage deviation, it indicates that one battery cell with index i in one of the battery modules is faulty. The corresponding battery module is then able to be identified based on the BMS that uploads the data. Conversely, it indicates that all the battery cells with index i are deemed normal.

In one embodiment, the step of performing a vertical comparison on the battery cells, calculating a difference between the deviations of the battery cells with the same index within each of the battery modules and a median value of the deviations of the battery cells with the same index within each of the battery modules, and if the difference exceeds the upper threshold for the cell voltage deviation, determining that the battery cell corresponding to the difference is faulty, further includes: determining an index of battery cells for which the difference exceeds the upper threshold for the cell voltage deviation; determining, based on the index of the battery cells, a BMS that uploads data; and determining a corresponding battery module based on the BMS that uploads the data.

In this embodiment, since each battery cell within each of the battery modules has already been assigned an index, each battery cell has a unique index. Based on the index, the corresponding battery module and the position of each battery cell are able to be determined. In this way, during fault detection of battery cells, the problem of index confusion is able to be avoided, allowing accurate identification of the faulty battery cell and the corresponding battery module, thereby enabling timely follow-up processing.

In one embodiment, each of the battery modules includes a BMS, and the battery cells in the each of the battery modules upload data to a microgrid controller via the BMS. The battery cells within the same battery module are connected in parallel to the BMS via external circuits. Therefore, the BMS is able to accurately measure the voltage information of each battery cell.

In one embodiment, the battery cell fault identification method for the energy storage system further includes: when a fault is detected in a battery cell of the battery cells, stopping charging and discharging of the battery module in which the faulty battery cell is located.

In one embodiment, the upper threshold for the cell voltage deviation is obtained through experiments or empirical formulas.

Referring to FIG. 2, according to the embodiments of the present invention, the energy storage system applies the battery cell fault identification method for the energy storage system described above. The energy storage system includes: n battery modules, the battery modules being arranged in parallel, wherein each of the battery modules includes a BMS and a plurality of battery cells, and the plurality of battery cells are connected in series and/or in parallel; and a microgrid controller, communicatively connected with the BMS of each of the battery modules to acquire battery module parameters collected by the BMS and process the battery module parameters.

In this embodiment, the energy storage system includes n battery modules. Each battery module is formed by connecting i battery cells in series or in parallel. Each battery module is configured with a BMS for collecting cell voltage information. Each BMS is electrically connected with the microgrid controller, wherein the microgrid controller is used to receive the cell voltage information and temperature information of all battery cells collected by the BMSs, and to process and analyze the information. One microgrid controller corresponds to multiple BMSs: BMS#1~BMS#n, and sets an upper threshold for an internal resistance deviation of the battery cells.

In one embodiment, the energy storage system further includes an energy storage converter, which is connected with all the battery modules and controls charging and discharging of the battery modules.

In one embodiment, all the battery modules in the energy storage system are charged and discharged with equal power, ensuring that the voltage performance of each battery module is not affected by the discharge rate.

In one embodiment, the energy storage converter is electrically connected with the microgrid controller, and when detecting a fault in at least one battery cell of the plurality of battery cells, the microgrid controller issues a shutdown instruction to the energy storage converter to stop charging and discharging the battery modules.

In one embodiment, all the battery modules in the energy storage system are cooled in a liquid cooling manner. This method results in smaller temperature differences between different modules. Compared to an air-cooling system, liquid cooling is not affected by spatial location and offers a better cooling effect. Therefore, the battery temperature is able to be more effectively controlled.

In one embodiment, the BMS adopts a STM32f4 series microcontroller, and an MC uses an ARM-A8 processor.

The embodiments of the present invention have the following advantages:
1) Improved fault detection accuracy: By setting the average cell voltage of all battery modules as a unified reference, a vertical comparison of the cell voltages of the battery cells with the same index or at the same position across different battery modules is able to be achieved. This enables precise calculation of voltage deviations. When the voltage deviates from the threshold, the microgrid controller is able to accurately detect the fault at the earliest time;
2) Avoidance of false positives and false negatives: The present invention eliminates the consistency problem caused by design and manufacturing at the initial stage. By comparing battery cells with the same index or position, the problem that faulty battery cells with initially high or low voltages may experience voltage drop or rise without being detected by the system is completely avoided. Additionally, the problem of misjudging some battery cells with initially high voltages as non-faulty due to slight upward voltage deviations is prevented, thereby enhancing the accuracy of system diagnosis; and
3) Enhanced overall safety of the energy storage system at the system level: While the BMS performs fault protection on the energy storage system, the microgrid controller further utilizes system-wide data advantages to provide protection at the system level, thereby improving the overall safety of the system.

It should be noted that the terminology used herein is for the purpose of describing particular embodiments only and is not intended to limit the exemplary embodiments of the present invention. As used herein, unless the context clearly dictates otherwise, the singular forms are intended to include the plural forms as well. It should also be understood that the terms "comprise" and/or "include", as used in this specification, specify the presence of stated features, steps, operations, devices, components, and/or combinations thereof.

It should be noted that the terms "first", "second", etc. in the description and claims of the present invention and the accompanying drawings are used for distinguishing similar objects, but not necessarily used for describing any particular order or chronological order. It is to be understood that the data so used are interchangeable under appropriate circumstances such that the embodiments of the present invention described herein can be practiced in sequence other than those illustrated or described herein.

The embodiments described above are merely some embodiments of the present invention and is not intended to limit the present invention which may be subject to various modifications and variations to those skilled in the art. Any modification, equivalent replacement, improvement, etc. made within the spirit and principles of the present invention should fall within the scope of protection of the present invention.

## Claims

1. A battery cell fault identification method for an energy storage system, comprising:
setting an upper threshold for a cell voltage deviation;
acquiring a cell voltage V_n_i of each battery cell, wherein n denotes a number of battery modules, and i denotes an index of battery cells within each of the battery modules;
performing a horizontal comparison on the battery cells to acquire a deviation ΔV_n_i of the cell voltage of each of battery cells within a same battery module relative to an average cell voltage of the battery cells within the same battery module; and
performing a vertical comparison on the battery cells, calculating a difference between deviations of battery cells with a same index within each of the battery modules and a median value of the deviations of the battery cells with a same index within the each of the battery modules, and if the difference exceeds the upper threshold for the cell voltage deviation, determining that a battery cell corresponding to the difference is faulty.

2. The battery cell fault identification method for the energy storage system according to claim 1, wherein a step of performing a horizontal comparison on the battery cells to acquire a deviation ΔV_n_i of the cell voltage of each of the battery cells within a same battery module relative to an average cell voltage of the battery cells within the same battery module comprises:
acquiring an average cell voltage within an nth battery module: ave_v_n=(v_1+v_2+...v_i)/i; and
calculating the deviation of the cell voltage V_n_i within the same battery module relative to the average cell voltage, wherein ΔV_n_i=V_n_i-ave_v_n.

3. The battery cell fault identification method for the energy storage system according to claim 1, wherein a step of performing a vertical comparison on the battery cells to calculate a difference between the deviations of the battery cells with the same index within each of the battery modules and a median value of the deviations of the battery cells with the same index within each of the battery modules, and if the difference exceeds the upper threshold for the cell voltage deviation, determining that the battery cell corresponding to the difference is faulty, comprises:
sorting the deviations ΔV_n_i of cell voltages of the battery cells with the same index within all the battery modules in ascending order, and acquiring the median value H_n_imid, a maximum value H_n_imax and a minimum value H_n_imin of the deviations ΔV_n_i of the cell voltages of the battery cells with the same index; and
calculating a maximum voltage deviation value of the battery cells with the same index relative to the median value, expressed as: MAX = max[(H_n_imax-H_n_imid), (H_n_imid-H_n_imin)].

4. The battery cell fault identification method for the energy storage system according to claim 3, wherein the step of performing a vertical comparison on the battery cells, calculating a difference between the deviations of the battery cells with the same index within each of the battery modules and a median value of the deviations of the battery cells with the same index within each of the battery modules, and if the difference exceeds the upper threshold for the cell voltage deviation, determining that the battery cell corresponding to the difference is faulty, further comprises:
determining an index of battery cells for which the difference exceeds the upper threshold for the cell voltage deviation;
determining, based on the index of the battery cells, a BMS that uploads data; and
determining a corresponding battery module based on the BMS that uploads the data.

5. The battery cell fault identification method for the energy storage system according to claim 1, wherein each of the battery modules comprises a BMS, and the battery cells in the each of the battery modules upload data to a microgrid controller via the BMS.

6. The battery cell fault identification method for the energy storage system according to claim 1, further comprising:
when a fault is detected in a battery cell of the battery cells, stopping charging and discharging of the battery module in which the faulty battery cell is located.

7. The battery cell fault identification method for the energy storage system according to claim 1, wherein the upper threshold for the cell voltage deviation is obtained through experiments or empirical formulas.

8. An energy storage system applying the battery cell fault identification method according to any one of claims 1 to 7, comprising:
n battery modules, the battery modules being arranged in parallel, wherein each of the battery modules comprises a BMS and a plurality of battery cells, and the plurality of battery cells are connected in series and/or in parallel; and
a microgrid controller, communicatively connected with the BMS of each of the battery modules to acquire battery module parameters collected by the BMS and process the battery module parameters.

9. The energy storage system according to claim 8, further comprising an energy storage converter, which is connected with all the battery modules and controls charging and discharging of the battery modules.

10. The energy storage system according to claim 9, wherein the energy storage converter is electrically connected with the microgrid controller, and when detecting a fault in at least one battery cell of the plurality of battery cells, the microgrid controller issues a shutdown instruction to the energy storage converter to stop charging and discharging of the battery modules.
